# EUROPEAN PATENT SPECIFICATION

(11) **EP 3 699 048 B1**
(45) Date of publication and mention of the grant of the patent: **30.11.2022**
(21) Application number: 20158116.2
(22) Date of filing: 19.02.2020
(51) Int. Cl.: B60W 30/095, B60W 60/00

(54) **TRAVELLING TRACK PREDICTION METHOD AND DEVICE FOR VEHICLE**
FAHRWEGVORHERSAGEVERFAHREN UND -VORRICHTUNG FÜR FAHRZEUG
PROCÉDÉ DE PRÉDICTION DE TRAJECTOIRES ET DISPOSITIF POUR VÉHICULE

(30) Priority: 20.02.2019 CN 201910127534
(43) Date of publication of application: 26.08.2020
(73) Proprietor: Apollo Intelligent Driving Technology (Beijing) Co., Ltd., Haidian District Beijing 100085 (CN)
(72) Inventor: ZHAN, Kun, Beijing, 100085 (CN); YANG, Xuguang, Beijing, 100085 (CN); PAN, Yifeng, Beijing, 100085 (CN); CHEN, Zhongtao, Beijing, 100085 (CN); XU, Kecheng, Beijing, 100085 (CN); JIANG, Feiyi, Beijing, 100085 (CN)
(74) Representative: Brevalex

(56) References cited:
- EP-A1- 2 562 060
- US-A1- 2017 162 050
- US-A1- 2017 210 379
- US-B1- 8 457 827

## Description

### TECHNICAL FIELD

The invention relates to the technical field of automatic drive, and more particularly to a travelling track prediction method and device for a vehicle.

### BACKGROUND

When a current autonomous vehicle is travelling on a road, it is necessary to predict a track of a target vehicle around the main vehicle to determine a track thereof. In the existing technology, a method for predicting a travelling track of the target vehicle is performed by predicting the track of the target vehicle in a next relatively long time period according to a current state, a lane line or a map reference line of the target vehicle. However, during practical travelling on a road, in case of an emergency brake, overtaking lane-changing or a traffic accident of the target vehicle, it is very difficult to predict the track in a physical logic manner only based on the current state and lane information of the target vehicle, and thus the predicted track cannot be made reference to in planning a track for the main vehicle. On the other hand, since a driving intention of a driver of a manned vehicle may be changed over time, predicting a track of the target vehicle within a relatively long time in the existing technology may not reflect a real intention of the manned vehicle.
US 2017/162050 A1 discloses a travelling track prediction method for a vehicle, comprising: calculating a plurality of potential positions to which is to be reached by a target vehicle within a preset time within a sensible range of a main vehicle, and selecting at least one travelling track to a potential position from a plurality of travelling tracks as a prediction result of the target vehicle based on environment information around the target vehicle.

The above information disclosed in the background is only described to strengthen an understanding to the background technology of the disclosure and thus may include information not forming the existing technology well-known to a person skilled in the art.

### SUMMARY

A travelling track prediction method and device for a vehicle are provided according to the invention, to solve one or more technical problems in the conventional art.

According to a first aspect of the invention, a travelling track prediction method for a vehicle is provided, comprising:
calculating a plurality of potential positions to which is to be reached by a target vehicle within a preset time within a sensible range of a main vehicle;
selecting at least two positions from the plurality of potential positions as target positions;
predicting a plurality of travelling tracks to each target position for the target vehicle based on travelling state information of the target vehicle; and
selecting at least one track from the plurality of tracks as a prediction result of travelling track of the target vehicle based on environment information around the target vehicle.

In an implementation, the method may further include:
acquiring the target vehicle within the sensible range of the main vehicle; and
acquiring travelling data of historical frames of the target vehicle and road information around the target vehicle.

In an implementation, the calculating a plurality of potential positions to which is to be reached by a target vehicle within a preset time within a sensible range of a main vehicle may include:
selecting available road information of the target vehicle according to the road information around the target vehicle; and
calculating a plurality of potential positions to which is to be reached by the target vehicle within a preset time by a prediction model, according to the travelling data of historical frames of the target vehicle and the available road information of the target vehicle.

In an implementation, the selecting at least two positions from the plurality of potential positions as target positions may include:
acquiring probabilities of the target vehicle to the potential positions; and
selecting at least two potential positions with highest two probabilities as the target positions, wherein if a road where the target vehicle is currently located has a plurality of lanes, the target positions are located on different lanes respectively.

In an implementation, the predicting a plurality of travelling tracks to each target position for the target vehicle based on travelling state information of the target vehicle may include:
acquiring travelling state information of historical frames of the target vehicle within a preset time; and
calculating a plurality of travelling tracks of the target vehicle to each target position with a preset algorithm, according to the travelling state information of historical frames of the target vehicle within the preset time.

In an implementation, the selecting at least one travelling track from the plurality of travelling tracks as a prediction result of the target vehicle based on environment information around the target vehicle may include:
acquiring road information and obstacle information in the environment information around the target vehicle, and
selecting at least one travelling track from the plurality of travelling tracks as the prediction result with a preset algorithm based on the road information and the obstacle information.

According to a second aspect of the invention, a travelling track prediction device for a vehicle is provided, comprising:
a position calculating module configured to calculate a plurality of potential positions to which is to be reached by a target vehicle within a preset time within a sensible range of a main vehicle;
a selecting module configured to select at least two positions from the plurality of potential positions as target positions;
a travelling track module configured to predict a plurality of travelling tracks to each target position for the target vehicle based on travelling state information of the target vehicle; and
a predicting module configured to select at least one travelling track from the plurality of travelling tracks as a prediction result of the target vehicle based on environment information around the target vehicle.

In an implementation, the device may further include:
a first acquiring module configured to acquire the target vehicle within the sensible range of the main vehicle; and
a second acquiring module configured to acquire travelling data of historical frames of the target vehicle and road information around the target vehicle.

In an implementation, the position calculating module may include:
a road selecting sub-module configured to select available road information of the target vehicle according to the road information around the target vehicle; and
a position calculating sub-module configured to calculate a plurality of potential positions to which is to be reached by the target vehicle within a preset time by a prediction model, according to the travelling data of historical frames of the target vehicle and the available road information of the target vehicle.

In an implementation, the selecting module may include:
a probability acquiring sub-module configured to acquire probabilities of the target vehicle to the potential positions; and
a probability selecting sub-module configured to select at least two potential positions with highest two probabilities as the target positions, wherein if a road where the target vehicle is currently located has a plurality of lanes, the target positions are located on different lanes respectively.

In an implementation, the travelling track module may include:
a historical frame acquiring sub-module configured to acquire travelling state information of historical frames of the target vehicle within a preset time; and
a calculating sub-module configured to calculate a plurality of travelling tracks of the target vehicle to each target position with a preset algorithm, according to the travelling state information of historical frames of the target vehicle within the preset time.

In an implementation, the predicting module may include:
an information acquiring sub-module configured to acquire road information and obstacle information in the environment information around the target vehicle, and
a selecting sub-module configured to select at least one travelling track from the plurality of travelling tracks as the prediction result with a preset algorithm based on the road information and the obstacle information.

According to a third aspect and a fourth aspect of the invention, a computer-readable medium according to claim 13 and a computer program product according to claim 14 are provided.

One technical solution in the technical solutions has the following advantages or beneficial effects. A travelling track of the target vehicle around the main vehicle can be accurately predicted based on the travelling state information and the environment information. Therefore, a travelling track of the main vehicle can be accurately planned according to the predicted travelling track of the target vehicle.

In addition to the illustrative aspects, embodiments, and features described above, further aspects, embodiments, and features of the invention will be readily understood by reference to the drawings and the following detailed description.

### BRIEF DESCRIPTION OF DRAWINGS

In the drawings, unless otherwise specified, identical reference numerals will be used throughout the drawings to refer to identical or similar parts or elements. The drawings are not necessarily drawn to scale. It should be understood that these drawings depict only some embodiments disclosed in accordance with the invention and are not to be considered as limiting the scope of the invention.
FIG. 1 is a flowchart of a travelling track prediction method for a vehicle according to an implementation of the invention.
FIG. 2 is a flowchart of a travelling track prediction method for a vehicle according to another implementation of the invention.
FIG. 3 is a specific flowchart of S100 in a travelling track prediction method for a vehicle according to an implementation of the invention.
FIG. 4 is a specific flowchart of S200 in a travelling track prediction method for a vehicle according to an implementation of the invention.
FIG. 5 is a specific flowchart of S300 in a travelling track prediction method for a vehicle according to an implementation of the invention.
FIG. 6 is a specific flowchart of S400 in a travelling track prediction method for a vehicle according to an implementation of the invention.
FIG. 7 is a schematic diagram of an application scenario of a travelling track prediction method for a vehicle according to an implementation of the invention.
FIG. 8 is a structure diagram of a travelling track prediction device for a vehicle according to an implementation of the invention.
FIG. 9 is a structure diagram of a travelling track prediction device for a vehicle according to another implementation of the invention.
FIG. 10 is a structure diagram of a travelling track prediction terminal for a vehicle according to an implementation of the invention.

### DETAILED DESCRIPTION

In the following, only certain exemplary embodiments are briefly described. As those skilled in the art would realize, the described embodiments may be modified in various different ways, all without departing from the scope of the invention as defined by the claims. Accordingly, the drawings and description are to be regarded as illustrative in nature and not restrictive.

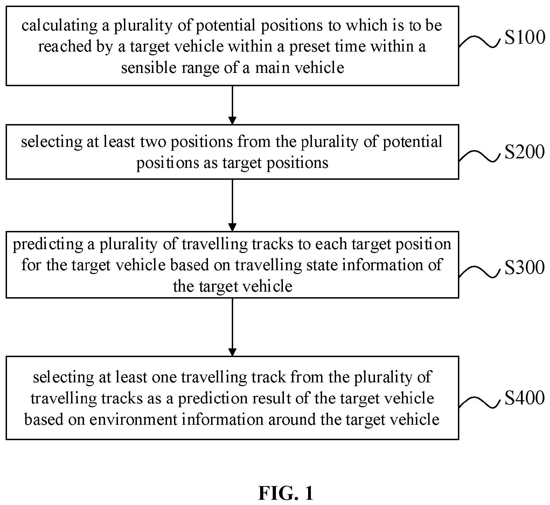

A travelling track prediction method for a vehicle is provided according to an embodiment of the invention. As shown in FIG. 1, the method includes steps S100 to S400.

In S100, a plurality of potential positions to which is to be reached by a target vehicle within a preset time within a sensible range of a main vehicle is calculated.

It is noted that the sensible range of the main vehicle may include a detection range of an acquisition device such as a radar, a sensor and a camera on the main vehicle, and environment information around the main vehicle may be acquired. It is also noted that the term "track" and "travelling track" may be used interchangeably.

The target vehicle may include all vehicles present within the sensible range of the main vehicle, for example, any type of vehicles such as a manned vehicle, an autonomous vehicle, a bicycle, a motorcycle and an electric vehicle.

When the target vehicle is travelling on a non-motor vehicle road, the plurality of positions as calculated may be in any region around the target vehicle. When the target vehicle is travelling on a motor vehicle road, the plurality of positions as calculated may be on different lanes of the road respectively. When the main vehicle is travelling depending on a high-definition map, the lanes may be divided according to lane lines in the high-definition map. The high-definition map is a map of a high-definition and precisely defined, and a definition thereof may reach a decimeter level. A real three-dimensional world is constructed by the high-definition map, and, besides shape information and topological relationships of absolute positions, attributes such as a point cloud, semantics, a feature and the like are even further included. Not only road-level navigation information and lane-level navigation information may be provided, but also accurate position information of a vehicle and adequate road data information may be provided. Therefore, for each calculated position, an absolute position relative to the position, a relative position in the map, road information and environment information around the position and any information related to the position may be accurately acquired by the main vehicle.

The preset time may be customized according to a track prediction requirement. For example, the preset time is selected according to a length of a track of the target vehicle required to be predicted or according to a condition of prediction accuracy and the like. For ensuring that the plurality of potential positions as calculated of the target vehicle can be made reference to, the preset time should not be set to be too short or too long. If the preset time is set too short, there is no obvious difference between the calculated potential position and a current position of the target vehicle, and an intention of the target vehicle may not be reflected. If the preset time is set too long, an accuracy of the calculated potential position may be reduced. Since the track of the target vehicle may also be adjusted in real time during travelling according to an ambient condition, a relatively great error may be caused in the calculated position relative to a position that the target vehicle actually reaches, thereby disturbing subsequent accurate prediction of the track of the target vehicle.

In S200, at least two positions from the plurality of potential positions are selected as target positions.

It is noted that a large number of potential positions may be calculated according to environment around the main vehicle and the target vehicle. However, these positions may not always affect a future track of the main vehicle. Therefore, for reducing a calculation cost for the main vehicle, a small number of positions may be selected from the plurality of potential positions as the target positions according to a customized rule. For example, the customized rule is determined according to a probability of reaching each potential position, a lane of great interest, a complexity of environment around the potential position and the like.

In S300, a plurality of travelling tracks to each target position for the target vehicle is predicted based on travelling state information of the target vehicle.

The travelling state information may include any information of the target vehicle acquired by the main vehicle. For example, the travelling state information includes information such as a speed, an acceleration, a position, and a heading angle (headstock orientation) of the target vehicle, a distance between the target vehicle and a lane line, and a distance between the target vehicle and the main vehicle.

It is noted that, in case of different roads ahead of the target vehicle, different behavior of obstacles around the target vehicle, or different driving intentions of a driver of the target vehicle, there may be various types of tracks to the same position by the target vehicle, for example, a straight track, an arched track and a polyline track. Therefore, the tracks of the target vehicle to the target positions are required to be as much as possible to improve the accuracy of the predicted track.

In S400, at least one travelling track is selected from the plurality of travelling tracks as a prediction result of the target vehicle based on environment information around the target vehicle.

A method for selecting the travelling track may be determined according to a prediction requirement in advance. For example, a specified track of a certain type is selected according to a test requirement of a user of the main vehicle as the prediction result as well as a test object for a subsequent determination of the track of the main vehicle. For another example, an occurrence probability of each track is scored according to the environment information around the target vehicle, and a track with a relatively high score is selected as the prediction result.

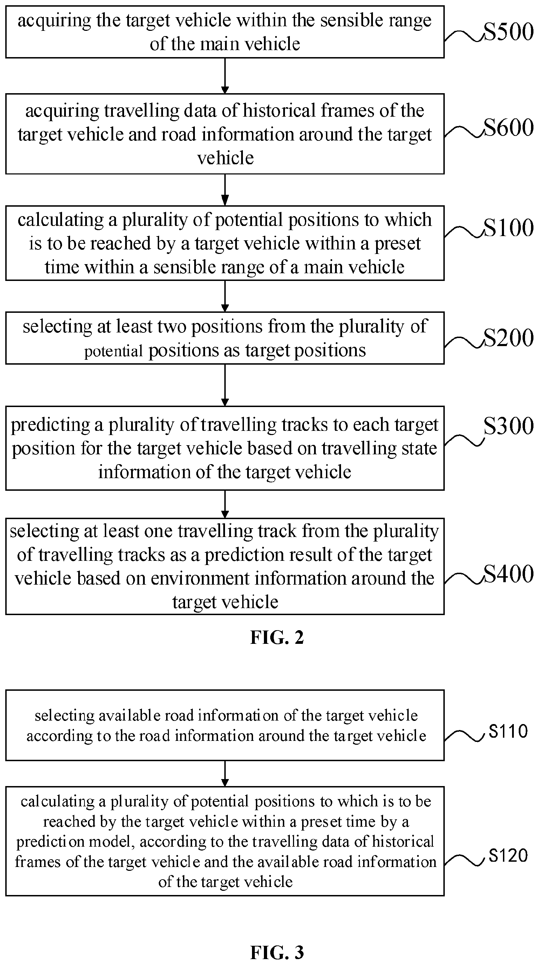

In an implementation, as shown in FIG. 2, the method may further include steps S500 to S600.

In S500, the target vehicle within the sensible range of the main vehicle is acquired.

In S600, travelling data of historical frames of the target vehicle and road information around the target vehicle are acquired.

The travelling data of historical frames may include travelling data of the target vehicle at the moment and travelling data of the target vehicle in historical travelling. The road information around the target vehicle may include road information around the target vehicle at the moment. When the main vehicle travels through the high-definition map, the road information around the target vehicle may be acquired through the high-definition map.

In an implementation, as shown in FIG. 3, the operation of calculating a plurality of potential positions to which is to be reached by a target vehicle within a preset time within a sensible range of a main vehicle is performed by steps S110 to S120.

In S110, available road information of the target vehicle is selected according to the road information around the target vehicle.

The road information may include traffic rule information, road type information and the like. The traffic rule information is, for example, no left turn ahead and no lane changing on this road. The road type information is, for example, a road type (for example, a crossroad, a straight road and a fork), a road curvature and a road connecting relationship. With the road information around the target vehicle, some unnecessary position calculation may be removed rapidly, and the calculation cost is reduced.

In an application example, it is known from the road information that the road ahead of the target vehicle is a crossroad and vehicles are forbidden to turn left at the crossroad. Accordingly, an available lane for the target vehicle may be selected to be a straight lane or a right-turn lane. With reference to the road information of the intersection, some impossible positions may be removed in advance before calculating the potential positions, thereby reducing the calculation cost and improving the calculation efficiency.

In S120, a plurality of potential positions to which is to be reached by the target vehicle within a preset time are calculated by a prediction model, according to the travelling data of historical frames of the target vehicle and the available road information of the target vehicle. The travelling data of historical frames may be used to predict a possible intention of the target vehicle, i.e., a movement direction of the target vehicle.

It is noted that the prediction model may be any model in the existing technology, as long as the potential positions may be predicted based on the travelling data of historical frames and the available road information. The travelling data of historical frames may include any information characterizing the target vehicle, such as the speed, the acceleration, the position, and the heading angle of the target vehicle, the distance between the target vehicle and the lane line, and the distance between the target vehicle and the main vehicle.

For example, the prediction model may be a Long Short-Term Memory (LSTM) model. Each road in the available road information is predicted through the LSTM model based on the preset time and the travelling data of historical frames of the target vehicle, and a probability that the target vehicle reaches each road in the available road information and an average acceleration are obtained.

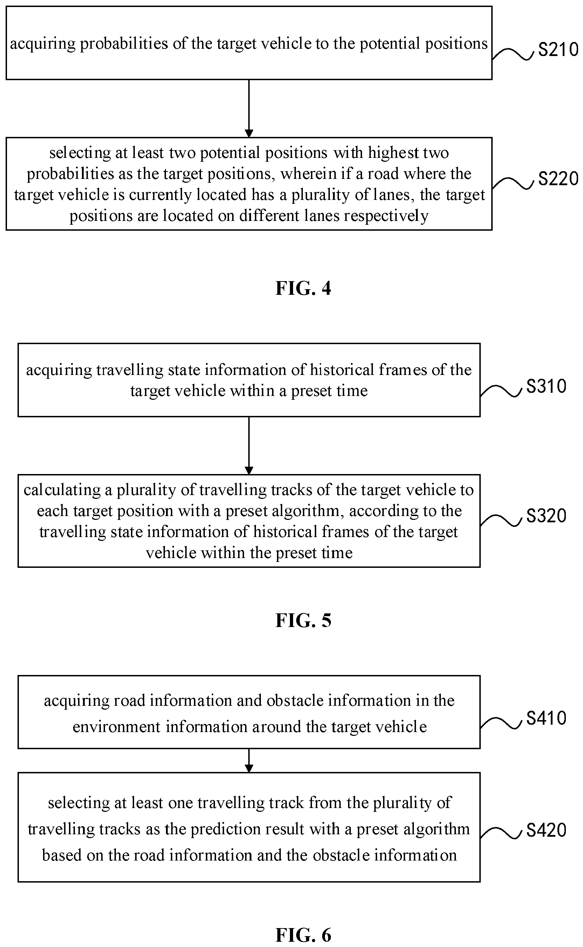

In an implementation mode, as shown in FIG. 4, the operation of selecting at least two positions from the plurality of potential positions as target positions is performed by steps S210 to S220.

In S210, probabilities of the target vehicle to the potential positions are acquired.

In S220, at least two potential positions with highest two probabilities are selected as the target positions, wherein if a road where the target vehicle is currently located has a plurality of lanes, the target positions are located on different lanes respectively.

In an implementation, as shown in FIG. 5, the operation of predicting a plurality of travelling tracks to each target position for the target vehicle based on travelling state information of the target vehicle is performed by steps S310 to S320.

In S310, travelling state information of historical frames of the target vehicle within a preset time is acquired.

The preset time may be customized according to the prediction requirements. Within one second, there may be travelling data of a plurality of historical frames. The travelling data of historical frames may include any information characterizing a historical travelling state of the target vehicle, such as the speed, the acceleration, the position, and the heading angle of the target vehicle, the distance between the target vehicle and the lane line, and the distance between the target vehicle and the main vehicle.

It is noted that the travelling data of the target vehicle at the moment is also considered as travelling data of historical frames. That is, all travelling data of the target vehicle that has been generated may be considered as travelling data of historical frames.

In S320, a plurality of travelling tracks of the target vehicle to each target position are calculated with a preset algorithm, according to the travelling state information of historical frames of the target vehicle within the preset time.

In an implementation, as shown in FIG. 6, the operation of selecting at least one travelling track from the plurality of travelling tracks as a prediction result of the target vehicle based on environment information around the target vehicle is performed by steps S410 to S420.

In S410, road information and obstacle information in the environment information around the target vehicle are acquired.

The road information includes information such as a road type, a road curvature and a road connecting relationship. The obstacle information includes any visible object except the target vehicle, such as other travelling vehicles, a pedestrian and a barricade around the target vehicle.

In S420, at least one travelling track are selected from the plurality of travelling tracks as the prediction result with a preset algorithm based on the road information and the obstacle information.

In an implementation, when the main vehicle travels depending on the high-definition map, all the road information and all the obstacle information of the target vehicle runs from the current position to the target position may be acquired according to the high-definition map, so that a reasonable track may be selected more accurately as a final prediction result.

In a variable implementation, when the preset time as set in the calculating of the plurality of potential positions of the target vehicle is relatively short, namely distances between the current position of the target vehicle and the calculated potential positions are relatively small, the track may also be selected only according to the road information and the obstacle information around the current position of the target vehicle.

It is noted that the preset algorithm for calculating the plurality of travelling tracks the target vehicle to the target positions in S320 may be identical to that for selecting the at least one travelling track from the plurality of travelling tracks as the prediction result in S420.

For example, the preset algorithm may be a lattice planner algorithm. According to the lattice planner algorithm, the travelling state information of historical frames of the target vehicle is acquired to calculate a plurality of transverse one-dimensional tracks and a plurality of longitudinal one-dimensional tracks of the target vehicle from the current position to the target position. The transverse one-dimensional tracks and the longitudinal one-dimensional tracks are arranged and combined to synthesize a plurality of two-dimensional tracks the target vehicle from the current position to the target position. Then, according to the lattice planner algorithm, each track is scored through a loss function, and at least one track with a highest score is selected as the prediction result for outputting. The track of the main vehicle is planned for the main vehicle according to the prediction result of each target vehicle within the sensible range. Since the track of the target vehicle obtained according to the method of the embodiment of the disclosure is more accurate, the track planned for the main vehicle can also be more reasonable, and travelling safety of the main vehicle is improved.

In an implementation, the finally selected track includes travelling data of each frame of the target vehicle predicted in a process of the target vehicle to the target position along the track.

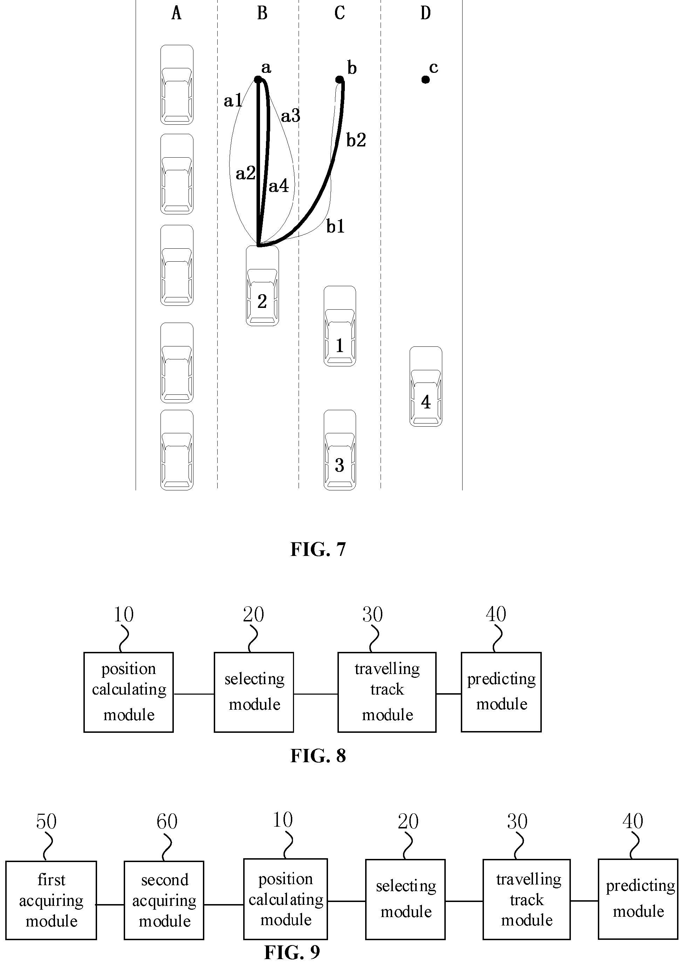

In an application scenario, as shown in FIG. 7, when a main vehicle 1 is travelling on a motor vehicle road, the motor vehicle road sequentially includes four lanes A, B, C and D from left to right in a direction presented in the figure. The main vehicle 1 learns that there are a target vehicle 2, a target vehicle 3 and a target vehicle 4 in a sensible range thereof through an acquisition device. The main vehicle 1 and the target vehicle 3 are located on the lane C, the target vehicle 2 is located on the lane B, and the target vehicle 4 is located on the lane D. For further understanding the travelling track prediction method for a vehicle of the embodiment of the disclosure, description will be made by performing the prediction for the target vehicle 2 as an example.

Specifically, road information around the target vehicle 2 is acquired based on a current position of the target vehicle 2, and it is leaned that a traffic accident happens in the lane A ahead on a left side of the target vehicle 2, leading to a road congestion of the lane A. Therefore, available road information of the target vehicle 2 are selected to be positions on the lane B, the lane C and the lane D.

Three positions a, b and c of the target vehicle 2 that may be reached 3 seconds later are calculated with the prediction model through travelling data of historical frames and available road information of the target vehicle 2 acquired by the main vehicle 1. The position a is located on the lane B, and a probability of travelling to the position a is 80%. The position b is located on the lane C, and a probability of travelling to the position b is 70%. The position c is located on the lane D, and a probability of travelling to the position c is 20%. The position a and the position b are selected as target positions according to the probabilities.

With the lattice planner algorithm and according to the travelling data of historical frames of the target vehicle 2, four probable tracks, i.e., tracks a1, a2, a3 and a4 are calculated for the target vehicle to the position a and there are three probable tracks, i.e., tracks b1, b2 and b3 respectively, for the target vehicle to the position b.

The tracks a1, a2, a3, a4, b1, b2 and b3 are scored through the lattice planner algorithm according to environment information around the target vehicle 2. It can be seen from a scoring result that the tracks a1 and a4 of the target vehicle 2 to the position a have the highest scores and the track b2 to the position b has the highest score. Therefore, the tracks a1 and a4 are determined as final predicted tracks for the target vehicle 2 to the position a, and the track b2 is determined as a final predicted track for the target vehicle 2 to the position b.

A travelling track prediction device for a vehicle is provided according to an embodiment of the invention, which, as shown in FIG. 8, includes:
a position calculating module 10 configured to calculate a plurality of potential positions to which is to be reached by a target vehicle within a preset time within a sensible range of a main vehicle;
a selecting module 20 configured to select at least two positions from the plurality of potential positions as target positions;
a travelling track module 30 configured to predict a plurality of travelling tracks to each target position for the target vehicle based on travelling state information of the target vehicle; and
a predicting module 40 configured to select at least one track from the plurality of tracks as a prediction result of travelling track of the target vehicle based on environment information around the target vehicle.

In an implementation, as shown in FIG. 9, the device further includes:
a first acquiring module 50 configured to acquire the target vehicle within the sensible range of the main vehicle; and
a second acquiring module 60 configured to acquire travelling data of historical frames of the target vehicle and road information around the target vehicle.

In an implementation, the position calculating module includes:
a road selecting sub-module configured to select available road information of the target vehicle according to the road information around the target vehicle; and
a position calculating sub-module configured to calculate a plurality of potential positions to which is to be reached by the target vehicle within a preset time by a prediction model, according to the travelling data of historical frames of the target vehicle and the available road information of the target vehicle.

In an implementation, the selecting module includes:
a probability acquiring sub-module configured to acquire probabilities of the target vehicle to the potential positions; and
a probability selecting sub-module configured to select at least two potential positions with highest two probabilities as the target positions, wherein if a road where the target vehicle is currently located has a plurality of lanes, the target positions are located on different lanes respectively.

In an implementation, the travelling track module includes:
a historical frame acquiring sub-module configured to acquire travelling state information of historical frames of the target vehicle within a preset time; and
a calculating sub-module configured to calculate a plurality of travelling tracks of the target vehicle to each target position with a preset algorithm, according to the travelling state information of historical frames of the target vehicle within the preset time.

In an implementation, the predicting module includes:
an information acquiring sub-module configured to acquire road information and obstacle information in the environment information around the target vehicle, and
a selecting sub-module configured to select at least one travelling track from the plurality of travelling tracks as the prediction result with a preset algorithm based on the road information and the obstacle information.

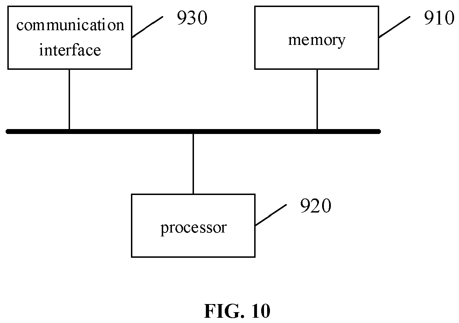

A travelling track prediction terminal for a vehicle is provided according to an example beyond the scope of the claims. The example, as shown in FIG. 10, includes:
a memory 910 and a processor 920. The memory 910 stores a computer program executable on the processor 920. When the processor 920 executes the computer program, the method for processing an audio signal in a vehicle in the foregoing embodiment is implemented. The number of the memory 910 and the processor 920 may be one or more.

A communication interface 930 configured to communicate with an external device and exchange data.

The memory 910 may include a high-speed RAM memory and may also include a non-volatile memory, such as at least one magnetic disk memory.

If the memory 910, the processor 920, and the communication interface 930 are implemented independently, the memory 910, the processor 920, and the communication interface 930 may be connected to each other through a bus and communicate with one another. The bus may be an Industry Standard Architecture (ISA) bus, a Peripheral Component (PCI) bus, an Extended Industry Standard Component (EISA) bus, or the like. The bus may be divided into an address bus, a data bus, a control bus, and the like. For ease of illustration, only one bold line is shown in FIG. 10, but it does not mean that there is only one bus or one type of bus.

Optionally, in a specific implementation, if the memory 910, the processor 920, and the communication interface 930 are integrated on one chip, the memory 910, the processor 920, and the communication interface 930 may implement mutual communication through an internal interface.

According to an embodiment of the invention, a computer-readable storage medium is provided for storing computer software instructions, which include programs involved in execution of the above the method.

The terms "first" and "second" are used for descriptive purposes only and are not to be construed as indicating or implying relative importance or implicitly indicating the number of indicated technical features. Thus, features defining "first" and "second" may explicitly or implicitly include at least one of the features. In the present description, "a plurality of' means two or more, unless expressly limited otherwise.

Any process or method descriptions described in flowcharts or otherwise herein may be understood as representing modules, segments or portions of code that include one or more executable instructions for implementing the steps of a particular logic function or process.

Logic and/or steps, which are represented in the flowcharts or otherwise described herein, for example, may be thought of as a sequencing listing of executable instructions for implementing logic functions, which may be embodied in any computer-readable medium, for use by or in connection with an instruction execution system, device, or apparatus (such as a computer-based system, a processor-included system, or other system that fetch instructions from an instruction execution system, device, or apparatus and execute the instructions). For the purposes of this specification, a "computer-readable medium" may be any device that may contain, store, communicate, propagate, or transport the program for use by or in connection with the instruction execution system, device, or apparatus. More specific examples (not a non-exhaustive list) of the computer-readable media include the following: electrical connections (electronic devices) having one or more wires, a portable computer disk cartridge (magnetic device), random access memory (RAM), read only memory (ROM), erasable programmable read only memory (EPROM or flash memory), optical fiber devices, and portable read only memory (CDROM). In addition, the computer-readable medium may even be paper or other suitable medium upon which the program may be printed, as it may be read, for example, by optical scanning of the paper or other medium, followed by editing, interpretation or, where appropriate, process otherwise to electronically obtain the program, which is then stored in a computer memory.

It should be understood that various of the described features may be implemented by hardware, software, firmware, or a combination thereof. In the above embodiments, multiple steps or methods may be implemented in software or firmware stored in memory and executed by a suitable instruction execution system. For example, if implemented in hardware, as in another embodiment, they may be implemented using any one or a combination of the following techniques well known in the art: discrete logic circuits having a logic gate circuit for implementing logic functions on data signals, application specific integrated circuits with suitable combinational logic gate circuits, programmable gate arrays (PGA), field programmable gate arrays (FPGAs), and the like.

Those skilled in the art may understand that all or some of the steps carried in the methods in the foregoing embodiments may be implemented by a program instructing relevant hardware. The program may be stored in a computer-readable storage medium, and when executed, one of the steps of the method embodiment or a combination thereof is included.

In addition, each of the functional units in the embodiments may be integrated in one processing module, or each of the units may exist alone physically, or two or more units may be integrated in one module. The above-mentioned integrated module may be implemented in the form of hardware or in the form of software functional module. When the integrated module is implemented in the form of a software functional module and is sold or used as an independent product, the integrated module may also be stored in a computer-readable storage medium. The storage medium may be a read only memory, a magnetic disk, an optical disk, or the like.

The foregoing descriptions are merely specific embodiments of the invention, but not intended to limit the protection scope of the invention. Those skilled in the art may easily conceive of various changes or modifications within the technical scope disclosed herein, all these should be covered within the protection scope of the invention. Therefore, the protection scope of the invention is defined by the claims.

## Claims

1. A travelling track prediction method for a vehicle, comprising:
calculating (S100) a plurality of potential positions to which is to be reached by a target vehicle within a preset time within a sensible range of a main vehicle;
selecting (S200) at least two positions from the plurality of potential positions as target positions;
predicting (S300) a plurality of travelling tracks to each target position for the target vehicle based on travelling state information of the target vehicle; and
selecting (S400) at least one travelling track from the plurality of travelling tracks as a prediction result of the target vehicle based on environment information around the target vehicle.

2. The travelling track prediction method of claim 1, further comprising:
acquiring (S500) the target vehicle within the sensible range of the main vehicle; and
acquiring (S600) travelling data of historical frames of the target vehicle and road information around the target vehicle.

3. The travelling track prediction method of claim 2, wherein calculating a plurality of potential positions to which is to be reached by a target vehicle within a preset time within a sensible range of a main vehicle comprises:
selecting (S110) available road information of the target vehicle according to the road information around the target vehicle; and
calculating (S120) the plurality of potential positions to which is to be reached by the target vehicle within the preset time by a prediction model, according to the travelling data of historical frames of the target vehicle and the available road information of the target vehicle.

4. The travelling track prediction method of any one of claims 1 to 3, wherein selecting at least two positions from the plurality of potential positions as target positions comprises:
acquiring (S210) probabilities of the target vehicle to the potential positions; and
selecting (S220) at least two potential positions with highest two probabilities as the target positions, wherein if a road where the target vehicle is currently located has a plurality of lanes, the target positions are located on different lanes respectively.

5. The travelling track prediction method of any one of claims 1 to 4, wherein predicting a plurality of travelling tracks to each target position for the target vehicle based on travelling state information of the target vehicle comprises:
acquiring (S310) travelling state information of historical frames of the target vehicle within the preset time; and
calculating (S320) the plurality of travelling tracks of the target vehicle to each target position with a preset algorithm, according to the travelling state information of historical frames of the target vehicle within the preset time.

6. The travelling track prediction method of any one of claims 1 to 5, wherein selecting at least one travelling track from the plurality of travelling tracks as a prediction result of the target vehicle based on environment information around the target vehicle comprises:
acquiring (S410) the road information and obstacle information in the environment information around the target vehicle; and
selecting (S420) at least one travelling track from the plurality of travelling tracks as the prediction result with the preset algorithm based on the road information and the obstacle information.

7. A travelling track prediction device for a vehicle, comprising:
a position calculating module (10) configured to calculate a plurality of potential positions to which is to be reached by a target vehicle within a preset time within a sensible range of a main vehicle;
a selecting module (20) configured to select at least two positions from the plurality of potential positions as target positions;
a travelling track module (30) configured to predict a plurality of travelling tracks to each target position for the target vehicle based on travelling state information of the target vehicle; and
a predicting module (40) configured to select at least one track from the plurality of tracks as a prediction result of travelling track of the target vehicle based on environment information around the target vehicle.

8. The travelling track prediction device of claim 7, wherein further comprising:
a first acquiring module (50) configured to acquire the target vehicle within the sensible range of the main vehicle; and
a second acquiring module (60) configured to acquire travelling data of historical frames of the target vehicle and road information around the target vehicle.

9. The travelling track prediction device of claim 8, wherein the position calculating module comprises:
a road selecting sub-module configured to select available road information of the target vehicle according to the road information around the target vehicle; and
a position calculating sub-module configured to calculate the plurality of potential positions to which is to be reached by the target vehicle within the preset time by a prediction model,
according to the travelling data of historical frames of the target vehicle and the available road information of the target vehicle.

10. The travelling track prediction device of any one of claims 7 to 9, wherein the selecting module comprises:
a probability acquiring sub-module configured to acquire probabilities of the target vehicle to the potential positions; and
a probability selecting sub-module configured to select at least two potential positions with highest two probabilities as the target positions, wherein if a road where the target vehicle is currently located has a plurality of lanes, the target positions are located on different lanes respectively.

11. The travelling track prediction device of any one of claims 7 to 10, wherein the travelling track module comprises:
a historical frame acquiring sub-module configured to acquire travelling state information of historical frames of the target vehicle within the preset time; and
a calculating sub-module configured to calculate the plurality of travelling tracks of the target vehicle to each target position with a preset algorithm, according to the travelling state information of historical frames of the target vehicle within the preset time.

12. The travelling track prediction device of any one of claims 7 to 11, wherein the predicting module comprises:
an information acquiring sub-module configured to acquire the road information and obstacle information in the environment information around the target vehicle, and
a selecting sub-module configured to select at least one travelling track from the plurality of travelling tracks as the prediction result with the preset algorithm based on the road information and the obstacle information.

13. A computer-readable storage medium, storing a computer program, wherein the program is executed by a processor to implement the method according to any one of claims 1 to 6.

14. A computer program product, comprising computer program instructions, that when executed by a processor, cause the processor to implement the method of any one of claims 1 to 6.

## Patentansprüche

1. Verfahren zum Vorhersagen eines Fahrwegs für ein Fahrzeug, umfassend:
Berechnen (S100) einer Vielzahl potenzieller Positionen, die ein Zielfahrzeug innerhalb einer vorgegebenen Zeit innerhalb eines zweckmäßigen Bereichs von einem Hauptfahrzeug erreichen soll;
Auswählen (S200) von mindestens zwei Positionen aus der Vielzahl potenzieller Positionen als Zielpositionen;
Vorhersagen (S300) einer Vielzahl von Fahrwegen zu jeder Zielposition für das Zielfahrzeug basierend auf Fahrzustandsinformationen des Zielfahrzeugs; und
Auswählen (S400) mindestens eines Fahrwegs aus der Vielzahl von Fahrwegen als ein Vorhersageergebnis des Zielfahrzeugs basierend auf Umgebungsinformationen im Umfeld des Zielfahrzeugs.

2. Verfahren zum Vorhersagen eines Fahrwegs nach Anspruch 1, ferner umfassend:
Erfassen (S500) des Zielfahrzeugs innerhalb des zweckmäßigen Bereichs von dem Hauptfahrzeug; und
Erfassen (S600) von Fahrdaten historischer Frames des Zielfahrzeugs und von Straßeninformationen im Umfeld des Zielfahrzeugs.

3. Verfahren zum Vorhersagen eines Fahrwegs nach Anspruch 2, wobei das Berechnen einer Vielzahl potenzieller Positionen, die ein Zielfahrzeug innerhalb einer vorgegebenen Zeit innerhalb eines zweckmäßigen Bereichs von einem Hauptfahrzeug erreichen soll, umfasst:
Auswählen (S110) verfügbarer Straßeninformationen des Zielfahrzeugs gemäß den Straßeninformationen im Umfeld des Zielfahrzeugs; und
Berechnen (S120) der Vielzahl potenzieller Positionen, die das Zielfahrzeug innerhalb der vorgegebenen Zeit erreichen soll, durch ein Vorhersagemodell gemäß den Fahrdaten historischer Frames des Zielfahrzeugs und den verfügbaren Straßeninformationen des Zielfahrzeugs.

4. Verfahren zum Vorhersagen eines Fahrwegs nach einem der Ansprüche 1 bis 3, wobei das Auswählen von mindestens zwei Positionen aus der Vielzahl potenzieller Positionen als Zielpositionen umfasst:
Erfassen (S210) von Wahrscheinlichkeiten des Zielfahrzeugs zu den potenziellen Positionen; und
Auswählen (S220) von mindestens zwei potenziellen Positionen mit den zwei höchsten Wahrscheinlichkeiten als die Zielpositionen, wobei, falls eine Straße, auf der sich das Zielfahrzeug gegenwärtig befindet, eine Vielzahl von Spuren aufweist, sich die Zielpositionen jeweils auf unterschiedlichen Spuren befinden.

5. Verfahren zum Vorhersagen eines Fahrwegs nach einem der Ansprüche 1 bis 4, wobei das Vorhersagen einer Vielzahl von Fahrwegen zu jeder Zielposition für das Zielfahrzeug basierend auf Fahrzustandsinformationen des Zielfahrzeugs umfasst:
Erfassen (S310) von Fahrzustandsinformationen historischer Frames des Zielfahrzeugs innerhalb der vorgegebenen Zeit; und
Berechnen (S320) der Vielzahl von Fahrwegen des Zielfahrzeugs zu jeder Zielposition mit einem vorgegebenen Algorithmus gemäß den Fahrzustandsinformationen historischer Frames des Zielfahrzeugs innerhalb der vorgegebenen Zeit.

6. Verfahren zum Vorhersagen eines Fahrwegs nach einem der Ansprüche 1 bis 5, wobei das Auswählen mindestens eines Fahrwegs aus der Vielzahl von Fahrwegen als ein Vorhersageergebnis des Zielfahrzeugs basierend auf Umgebungsinformationen im Umfeld des Zielfahrzeugs umfasst:
Erfassen (S410) der Straßeninformationen und von Hindernisinformationen in den Umgebungsinformationen im Umfeld des Zielfahrzeugs; und
Auswählen (S420) mindestens eines Fahrwegs aus der Vielzahl von Fahrwegen als das Vorhersageergebnis mit dem vorgegebenen Algorithmus basierend auf den Straßeninformationen und den Hindernisinformationen.

7. Vorrichtung zum Vorhersagen eines Fahrwegs für ein Fahrzeug, umfassend:
ein Positionsberechnungsmodul (10), das konfiguriert ist zum Berechnen einer Vielzahl potenzieller Positionen, die ein Zielfahrzeug innerhalb einer vorgegebenen Zeit innerhalb eines zweckmäßigen Bereichs von einem Hauptfahrzeug erreichen soll;
ein Auswahlmodul (20), das konfiguriert ist zum Auswählen von mindestens zwei Positionen aus der Vielzahl potenzieller Positionen als Zielpositionen;
ein Fahrwegmodul (30), das konfiguriert ist zum Vorhersagen einer Vielzahl von Fahrwegen zu jeder Zielposition für das Zielfahrzeug basierend auf Fahrzustandsinformationen des Zielfahrzeugs; und
ein Vorhersagemodul (40), das konfiguriert ist zum Auswählen mindestens eines Wegs aus der Vielzahl von Wegen als ein Vorhersageergebnis des Fahrwegs des Zielfahrzeugs basierend auf Umgebungsinformationen im Umfeld des Zielfahrzeugs.

8. Vorrichtung zum Vorhersagen eines Fahrwegs nach Anspruch 7, wobei sie ferner umfasst:
ein erstes Erfassungsmodul (50), das konfiguriert ist zum Erfassen des Zielfahrzeugs innerhalb des zweckmäßigen Bereichs von dem Hauptfahrzeug; und
ein zweites Erfassungsmodul (60), das konfiguriert ist zum Erfassen von Fahrdaten historischer Frames des Zielfahrzeugs und von Straßeninformationen im Umfeld des Zielfahrzeugs.

9. Vorrichtung zum Vorhersagen eines Fahrwegs nach Anspruch 8, wobei das Positionsberechnungsmodul umfasst:
ein Straßenauswahluntermodul, das konfiguriert ist zum Auswählen verfügbarer Straßeninformationen des Zielfahrzeugs gemäß den Straßeninformationen im Umfeld des Zielfahrzeugs; und
ein Positionsberechnungsuntermodul, das konfiguriert ist zum Berechnen der Vielzahl potenzieller Positionen, die das Zielfahrzeug innerhalb der vorgegebenen Zeit erreichen soll, durch ein Vorhersagemodell gemäß den Fahrdaten historischer Frames des Zielfahrzeugs und den verfügbaren Straßeninformationen des Zielfahrzeugs.

10. Vorrichtung zum Vorhersagen eines Fahrwegs nach einem der Ansprüche 7 bis 9, wobei das Auswahlmodul umfasst:
ein Wahrscheinlichkeitserfassungsuntermodul, das konfiguriert ist zum Erfassen von Wahrscheinlichkeiten des Zielfahrzeugs zu den potenziellen Positionen; und
ein Wahrscheinlichkeitsauswahluntermodul, das konfiguriert ist zum Auswählen von mindestens zwei potenziellen Positionen mit den zwei höchsten Wahrscheinlichkeiten als die Zielpositionen, wobei, falls eine Straße, auf der sich das Zielfahrzeug gegenwärtig befindet, eine Vielzahl von Spuren aufweist, sich die Zielpositionen jeweils auf unterschiedlichen Spuren befinden.

11. Vorrichtung zum Vorhersagen eines Fahrwegs nach einem der Ansprüche 7 bis 10, wobei das Fahrwegmodul umfasst:
ein Historisches-Frame-Erfassungsuntermodul, das konfiguriert ist zum Erfassen von Fahrzustandsinformationen historischer Frames des Zielfahrzeugs innerhalb der vorgegebenen Zeit; und
ein Berechnungsuntermodul, das konfiguriert ist zum Berechnen der Vielzahl von Fahrwegen des Zielfahrzeugs zu jeder Zielposition mit einem vorgegebenen Algorithmus gemäß den Fahrzustandsinformationen historischer Frames des Zielfahrzeugs innerhalb der vorgegebenen Zeit.

12. Vorrichtung zum Vorhersagen eines Fahrwegs nach einem der Ansprüche 7 bis 11, wobei das Vorhersagemodul umfasst:
ein Informationserfassungsuntermodul, das konfiguriert ist zum Erfassen der Straßeninformationen und von Hindernisinformationen in den Umgebungsinformationen im Umfeld des Zielfahrzeugs, und
ein Auswahluntermodul, das konfiguriert ist zum Auswählen mindestens eines Fahrwegs aus der Vielzahl von Fahrwegen als das Vorhersageergebnis mit dem vorgegebenen Algorithmus basierend auf den Straßeninformationen und den Hindernisinformationen.

13. Computerlesbares Speichermedium, das ein Computerprogramm speichert, wobei das Programm durch einen Prozessor ausgeführt wird, um das Verfahren nach einem der Ansprüche 1 bis 6 zu implementieren.

14. Computerprogrammprodukt, das Computerprogrammanweisungen umfasst, die bei Ausführung durch einen Prozessor bewirken, dass der Prozessor das Verfahren nach einem der Ansprüche 1 bis 6 implementiert.

## Revendications

1. Procédé de prédiction de trajectoire pour un véhicule, comprenant :
le calcul (S100) d'une pluralité de positions potentielles à atteindre par un véhicule cible dans un temps prédéfini dans une plage sensible d'un véhicule principal ;
la sélection (S200) d'au moins deux positions à partir de la pluralité de positions potentielles en tant que positions cibles ;
la prédiction (S300) d'une pluralité de trajectoires vers chaque position cible pour le véhicule cible sur la base d'informations d'état de déplacement du véhicule cible ; et
la sélection (S400) d'au moins une trajectoire à partir de la pluralité de trajectoires en tant que résultat de prédiction du véhicule cible sur la base d'informations d'environnement autour du véhicule cible.

2. Procédé de prédiction de trajectoire selon la revendication 1, comprenant en outre :
l'acquisition (S500) du véhicule cible dans la plage sensible du véhicule principal ; et
l'acquisition (S600) de données de déplacement de trames historiques du véhicule cible et d'informations de route autour du véhicule cible.

3. Procédé de prédiction de trajectoire selon la revendication 2, dans lequel le calcul d'une pluralité de positions potentielles à atteindre par un véhicule cible dans un temps prédéfini dans une plage sensible d'un véhicule principal comprend :
la sélection (S110) d'informations de route disponibles du véhicule cible en fonction des informations de route autour du véhicule cible ; et
le calcul (S120) de la pluralité de positions potentielles à atteindre par le véhicule cible dans le temps prédéfini par un modèle de prédiction, en fonction des données de déplacement de trames historiques du véhicule cible et des informations de route disponibles du véhicule cible.

4. Procédé de prédiction de trajectoire selon l'une quelconque des revendications 1 à 3, dans lequel la sélection d'au moins deux positions à partir de la pluralité de positions potentielles en tant que positions cibles comprend :
l'acquisition (S210) de probabilités du véhicule cible vers les positions potentielles ; et
la sélection (S220) d'au moins deux positions potentielles présentant les deux probabilités les plus élevées en tant que positions cibles, dans lequel si une route où le véhicule cible est actuellement situé a une pluralité de voies, les positions cibles sont situées sur différentes voies respectivement.

5. Procédé de prédiction de trajectoire selon l'une quelconque des revendications 1 à 4, dans lequel la prédiction d'une pluralité de trajectoires vers chaque position cible pour le véhicule cible sur la base d'informations d'état de déplacement du véhicule cible comprend :
l'acquisition (S310) d'informations d'état de déplacement de trames historiques du véhicule cible dans le temps prédéfini ; et
le calcul (S320) de la pluralité de trajectoires du véhicule cible vers chaque position cible avec un algorithme prédéfini, en fonction des informations d'état de déplacement de trames historiques du véhicule cible dans le temps prédéfini.

6. Procédé de prédiction de trajectoire selon l'une quelconque des revendications 1 à 5, dans lequel la sélection d'au moins une trajectoire à partir de la pluralité de trajectoires en tant que résultat de prédiction du véhicule cible sur la base d'informations d'environnement autour du véhicule cible comprend :
l'acquisition (S410) des informations de route et des informations d'obstacle dans les informations d'environnement autour du véhicule cible ; et
la sélection (S420) d'au moins une trajectoire à partir de la pluralité de trajectoires en tant que résultat de prédiction avec l'algorithme prédéfini sur la base des informations de route et des informations d'obstacle.

7. Dispositif de prédiction de trajectoire pour un véhicule, comprenant :
un module de calcul de position (10) configuré pour calculer une pluralité de positions potentielles à atteindre par un véhicule cible dans un temps prédéfini dans une plage sensible d'un véhicule principal ;
un module de sélection (20) configuré pour sélectionner au moins deux positions à partir de la pluralité de positions potentielles en tant que positions cibles ;
un module de trajectoire (30) configuré pour prédire une pluralité de trajectoires vers chaque position cible pour le véhicule cible sur la base d'informations d'état de déplacement du véhicule cible ;
et
un module de prédiction (40) configuré pour sélectionner au moins une trajectoire à partir de la pluralité de trajectoires en tant que résultat de prédiction de trajectoire du véhicule cible sur la base d'informations d'environnement autour du véhicule cible.

8. Dispositif de prédiction de trajectoire selon la revendication 7, dans lequel comprenant en outre :
un premier module d'acquisition (50) configuré pour acquérir le véhicule cible dans la plage sensible du véhicule principal ; et
un second module d'acquisition (60) configuré pour acquérir des données de déplacement de trames historiques du véhicule cible et des informations de route autour du véhicule cible.

9. Dispositif de prédiction de trajectoire selon la revendication 8, dans lequel le module de calcul de position comprend :
un sous-module de sélection de route configuré pour sélectionner des informations de route disponibles du véhicule cible en fonction des informations de route autour du véhicule cible ; et
un sous-module de calcul de position configuré pour calculer la pluralité de positions potentielles à atteindre par le véhicule cible dans le temps prédéfini par un modèle de prédiction,
en fonction des données de déplacement de trames historiques du véhicule cible et des informations de route disponibles du véhicule cible.

10. Dispositif de prédiction de trajectoire selon l'une quelconque des revendications 7 à 9, dans lequel le module de sélection comprend :
un sous-module d'acquisition de probabilités configuré pour acquérir des probabilités du véhicule cible vers les positions potentielles ; et
un sous-module de sélection de probabilités configuré pour sélectionner au moins deux positions potentielles présentant les deux probabilités les plus élevées en tant que positions cibles, dans lequel si une route où le véhicule cible est actuellement situé a une pluralité de voies, les positions cibles sont situées sur différentes voies respectivement.

11. Dispositif de prédiction de trajectoire selon l'une quelconque des revendications 7 à 10, dans lequel le module de trajectoire comprend :
un sous-module d'acquisition de trames historiques configuré pour acquérir des informations d'état de déplacement de trames historiques du véhicule cible dans le temps prédéfini ; et
un sous-module de calcul configuré pour calculer la pluralité de trajectoires du véhicule cible vers chaque position cible avec un algorithme prédéfini, en fonction des informations d'état de déplacement de trames historiques du véhicule cible dans le temps prédéfini.

12. Dispositif de prédiction de trajectoire selon l'une quelconque des revendications 7 à 11, dans lequel le module de prédiction comprend :
un sous-module d'acquisition d'informations configuré pour acquérir les informations de route et les informations d'obstacle dans les informations d'environnement autour du véhicule cible, et
un sous-module de sélection configuré pour sélectionner au moins une trajectoire à partir de la pluralité de trajectoires en tant que résultat de prédiction avec l'algorithme prédéfini sur la base des informations de route et des informations d'obstacle.

13. Support de stockage lisible par ordinateur, stockant un programme informatique, dans lequel le programme est exécuté par un processeur pour mettre en œuvre le procédé selon l'une quelconque des revendications 1 à 6.

14. Produit de programme informatique, comprenant des instructions de programme informatique qui, lorsqu'elles sont exécutées par un processeur, amènent le processeur à mettre en œuvre le procédé selon l'une quelconque des revendications 1 à 6.
